# EUROPEAN PATENT APPLICATION

(11) **EP 1 594 171 A2**
(43) Date of publication of application: **09.11.2005**
(21) Application number: 05103630.9
(22) Date of filing: 02.05.2005
(51) Int. Cl.: H01L 33/00

(54) **Semiconductor light emitting device with flexible substrate**

(30) Priority: 05.05.2004 US 840459
(71) Applicant: Lumileds Lighting U.S., LLC, San Jose, California 95131 (US)
(72) Inventor: Haque, Ashim, S., c/o Lumileds Lighting, U.S., LLC, San Jose, CA California 95131 (US); Martin, Paul, S., c/o Lumileds Lighting, U.S., LLC, San Jose, CA California 95131 (US)
(74) Representative: van der Veer, Johannis Leendert

(57) **Abstract**

A device includes a flexible substrate, such as a polyimide substrate, and a semiconductor light emitting device, such as an LED, bonded on conductive regions on a first side of the flexible substrate in a flip chip configuration. The LED is bonded to the flexible substrate through, e.g., gold stud bumps. A plurality of LEDs may be bonded to the flexible substrate in different configurations, e.g., as individual LEDs, groups of LEDs or as LEDs having multiple chips. The flexible substrate may be spooled on a reel, e.g., for bonding and shipping purposes. In one embodiment, the structure is formed by providing a flexible substrate and a plurality of LEDs. Gold bumps are formed, e.g., on the contract regions of the flexible substrate or the contacts of the LEDs. The LEDs are bonded to the flexible substrate, e.g., using thermosonic or thermo-compression bonding, and the LEDs are then encapsulated.

## Description

### FIELD OF THE INVENTION

The present invention relates to a flexible mount for flip-chip architecture semiconductor light emitting devices such as light emitting diodes.

### BACKGROUND

Light emitting diodes ("LEDs") are solid-state light sources with multiple advantages. They are capable of providing light with high brightness reliably and thus find applications in displays, traffic lights, and indicators, among others. An important class of light emitting diodes is fabricated from one or more Group III elements, such as Gallium, Indium, or Aluminum, and the group V element of Nitrogen. These III-nitride LEDs are capable of emitting light across the visible spectrum and into the ultraviolet regime of the spectrum, and thus have many promising applications. Other light emitting diodes may be made from III-phosphide and III-arsenide materials systems, which emit in the amber, red, and infrared regions of the spectrum.

Traditionally, LEDs are fabricated by depositing an n-doped region, an active region and a p-doped region on a substrate. Some LEDs have an n-contact formed on one side of the device and the p-contact is formed on the opposite side of the device, creating a vertical device. Other LEDs have both contacts formed on the same side of the device, with light extracted through the contacts. Such a structure is referred to as an epitaxy-up device. In both a vertical device and an epitaxy-up device, much of the light generated by the active region exits the device through the p-contact. Since the p-contact typically includes a metal and/or a semi-transparent metal oxide in order to optimize its electrical conduction properties, the p-contact generally transmits light poorly, posing a design problem.

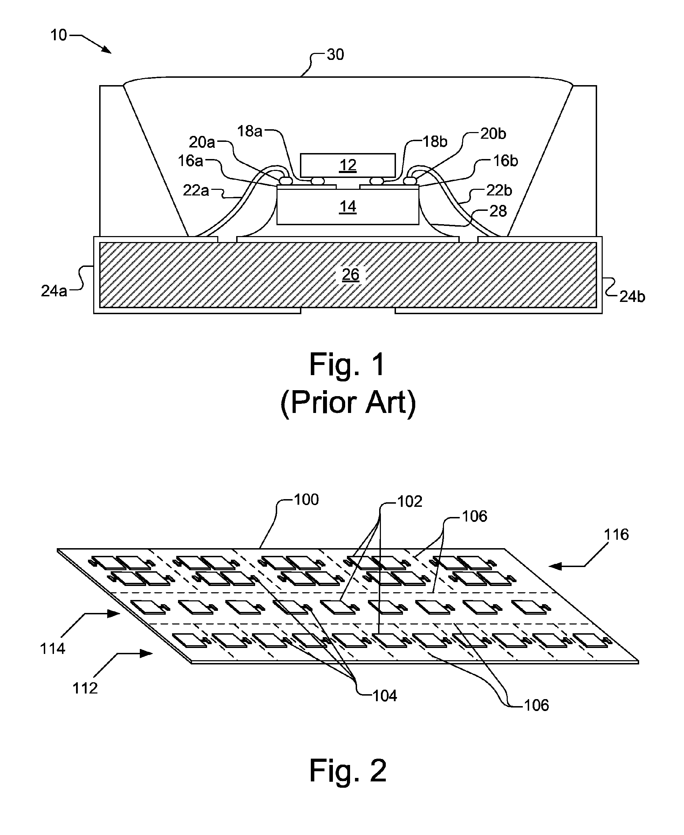

Recently, a flip chip architecture has been proposed in relation to this design problem. As shown in FIG. 1, in a flip chip device 10 the die 12 is mounted on a submount 14 with the contacts facing toward the submount 14. The device is completed by forming the submount 14, solderable layers 16a and 16b overlying the submount 14, and solder balls 18a and 18b on the solderable layers, and then attaching the die 12 to the solder balls 18a and 18b to provide electrical contact for the die.

Existing designs provide a path for the current by placing wire bonds in electrical contact with the solderable layers. The wire-bonds consist of balls 20a and 20b formed on the solderable layer, and connected wires 22a and 22b. The wires are then connectable to the package leads 24a and 24b of the package of the light emitting device. The submount 14 and the die 12 itself are attached to the lead frame 26 by a die epoxy 28. A lens 30, which may be formed from epoxy, is attached to the lead frame 26.

Conventional LED packages that include wire-bonded devices, such as that shown in Fig. 1, have several drawbacks. For example, the packages tend to be thick, which limits their uses in low form factor applications. The packages also tend to have a large footprint because wire-bonds require space on the submount outside the footprint of the LED. Further, if a multichip application is required, e.g., to produce white light using combinations of red, green and blue LEDs, the discrete LED packages demand a substantial real estate on the board.

Additionally, wire bonds are sensitive to heat. One of the limitations of the LED design is how much heating the wire bonds can endure. This issue becomes more and more important as newer generations of LEDs are planned to be operated at higher power and in higher temperature environments, leading to an increase in operating temperatures and heat production. The currents in the wires heat up the wires, a process referred to as ohmic heating. The degree of the ohmic heating is determined, among other things, by the current density. Elevated temperatures and repeated thermal cycling can lead to damage to the wire bond, such as separation of the ball from the solderable layer, brittleness in the wire, or breakage in the wire caused by melting at a narrow cross section. Such heating problems can also occur in case of an electrostatic discharge ("ESD"), or during transient periods, such as switching the device on and off. Elevated temperature operation can also lead to enhanced growth of physically brittle and electrically resistive intermetallic phases at the interface between balls 20 and solderable layers 16, which can ultimately cause failure at the interface.

Additionally, the wires are fragile and thus are usually the primary failure mechanism under extreme operating conditions, such as temperature shocks, rough handling or mechanical vibrations, and high humidity environments. In order to protect the fragile wire-bond, the LED must be assembled in a package to be of practical use for the end users. Moreover, most flip chip solder based LED packages contain lead based solder. The current trend, however, is towards environmentally friendly electronic components that are 100% lead free.

Accordingly, an improved LED packaging design is desired.

### SUMMARY

In accordance with an embodiment of the present invention, a device includes a semiconductor light emitting device and a flexible substrate, such as a polyimide substrate. The flexible substrate includes conductive regions to which the semiconductor light-emitting device is bonded in a flip chip configuration. The semiconductor light-emitting device is bonded to the flexible substrate through, e.g., gold stud bumps or the like.

In one embodiment, a structure includes a flexible substrate with a plurality of contact regions and a plurality of semiconductor light emitting devices physically and electrically connected to associated contact regions on the flexible substrate in flip chip configurations. The plurality of semiconductor light emitting devices may be bonded to the flexible substrate in different configurations, such as a number of individual light emitting devices, or as groups of light emitting devices. In one embodiment, the structure includes a reel upon which the flexible substrate is spooled, e.g., for shipping purposes.

In another embodiment, a method of forming a structure includes providing a flexible substrate with a plurality of contact regions and a plurality of semiconductor light emitting device, each having contacts on the same side of the device. Gold bumps are formed on either the contact regions of the flexible substrate or on the contacts of the semiconductor light emitting devices. The contacts of the semiconductor light emitting devices are then bonded to associated contact regions on the flexible substrate with the gold bumps. The semiconductor light emitting devices are then encapsulated. In one embodiment, individual or groups of semiconductor light emitting devices may be singulated from the flexible substrate. Alternatively, the flexible substrate with the bonded semiconductor light emitting devices may be spooled on a reel, e.g., for shipping purposes.

### BRIEF DESCRIPTION OF THE DRAWINGS

Fig. 1 illustrates a cross sectional view of a conventional flip chip device.
Fig. 2 illustrates a perspective view of a portion of a flexible substrate with a plurality of flip-chip architecture semiconductor light emitting devices mounted thereon.
Fig. 3A illustrates a method of producing a stud bump on a conductive region on a flexible substrate.
Fig. 3B illustrates a finished stud bump.
Fig. 4 illustrates bonding a semiconductor light-emitting device to the flexible substrate.
Fig. 5 illustrates a semiconductor light-emitting device bonded to the flexible substrate and covered with an encapsulant.
Fig. 6 illustrates a flexible substrate with bonded semiconductor light emitting devices being spooled on a reel.

### DETAILED DESCRIPTION

In accordance with an embodiment of the present invention, a plurality of semiconductor light emitting devices, such as LEDs, are packaged on a flexible substrate, which serves as the submount. The LEDs are electrically and thermally connected to the flexible substrate using, e.g., gold stud bumps or plating, which advantageously eliminates the need for a lead frame and wire bonds. The flexible substrate may be patterned to accommodate arrays of single chip LEDs or multichip LEDs. In addition, electro-static discharge (ESD) protection, such as Zener diodes, may be placed on the flexible substrate, along with the LED chips. The LEDs populated on the flexible substrate can be singulated in any form or shape, e.g., as individual LEDs, strips of LEDs, multiple LEDs. Additionally, an entire array of LEDs on a flexible substrate can be shipped without an additional tape and reel process.

Fig. 2 illustrates a perspective view of a portion of a flexible substrate 100 with a plurality of flip-chip architecture semiconductor light emitting devices, such as LEDs 102, mounted thereon. The flexible substrate 100 is a non-rigid material that can be physically bent or flexed without damage to the substrate. By way of example, the flexible substrate 100 may be a material that is sometimes referred to in the art as a flex circuit. Suitable material for flexible substrate 100 is manufactured by DuPont Corporation as Kapton® Polyimide Tape or 3M as Microflex circuit, or comparable product, such as Standard Flex, Novaflex®, or Reel Flex® manufactured by Sheldahl Corporation located in Northfield Minnesota. If desired, a single sided, double-sided or a multilayer flexible substrate may be used. Double-sided or multilayer flexible substrates may be used particularly where additional layers of electrical and thermal vias are desired. The flexible substrate 100 may be pre-patterned to produce the appropriate interconnects between the LEDs 102 and associated Zener diodes 104 and between multiple LEDs 102 if desired. Producing a desired pattern on a flexible substrate 100, such as Kapton® Polyimide Tape or Reel Flex®, is well known in the art. The use of flexible substrate 100 with LEDs 102 is advantageous as it eliminates the cost associated with conventional submounts. Moreover, the cost of conventional lead frame materials is also eliminated as the flexible substrate 100 may serve as the substrate that is directly attached to the end user's boards.

Any type of flip-chip architecture LED may be used with flexible substrate 100. Flip-chip style LEDs are well known in the art. Moreover, if desired, an ESD protection circuit 104 may be associated with each LED 102 and mounted on the flexible substrate 100. Examples of suitable ESD protection circuits include a capacitor in parallel with the LED, a single reverse-parallel diode such as a Zener or Schottky diode, and two oppositely coupled Zener diodes. For sake of simplicity, the ESD protection circuits 104 may be sometimes referred to herein as Zener diodes 104.

The LEDs 102 and associated Zener diodes 104 may be singulated from the flexible substrate 100 in different manners, as illustrated by broken lines 106. By way of example, along one row of the flexible substrate 100, illustrated generally by arrow 112, individual LEDs 102 and associated Zener diodes 104 may be singulated from the flexible substrate. Along another row, illustrated generally by arrow 114, a strip of LEDs 102 and associated Zener diodes 104 may be singulated from the flexible substrate 100. Further, along a row, illustrated by arrow 116, multiple LEDs 102 and associated Zener diodes 104 may be singulated together in groups. The use of multiple LEDs together may be particularly useful to produce white light as a combination of color light from the LEDs, e.g., red, green, blue, and blue (RGBB); or other appropriate combination.

While the flexible substrate 100 shown in Fig. 2 illustrates different types of arrangements of LEDs 102 and Zener diodes 104, other types of arrangements may be used. Moreover, it should be understood that the flexible substrate 100 may be populated by fewer or more arrangements if desired. By way of example, the flexible substrate may be populated with only multiple LEDs grouped together as illustrated along row 116 in Fig. 2.

The use of the flexible substrate 100 with LEDs 102 and Zener diodes 104 produces a package that is thinner than conventional single or multiple chip LEDs, which enables the use of LEDs in applications with tight volume restrictions, such as cell phones and camera flashes. By way of example, the present invention may be used to achieve an LED package profile of approximately 0.15mm to 0.2mm, whereas conventional LED package profiles are approximately 4.8mm to 6.00mm. Moreover, because the flexible substrate 100 is flexible, the LED package can be flexed or bent to easily fit into a non-linear or non-planar assembly if desired.

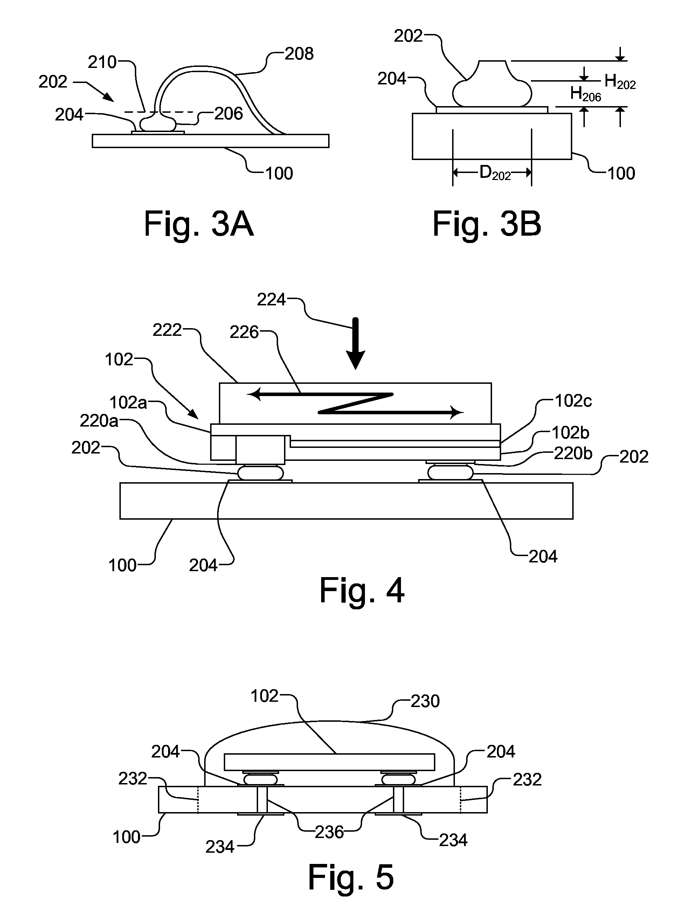

Figs. 3A, 3B, 4, and 5 illustrate the process of mounting an LED 102 on a flexible substrate 100, in accordance with an embodiment of the present invention. Once the flexible substrate 100 is patterned with desired conducting configuration, including conductive regions or pads, conductive bumps are produced on the pads of the flexible substrate. Fig. 3A illustrates a method of producing a stud bump 202 on a contact region, sometimes referred to as pad 204, on a flexible substrate 100. As illustrated, a wire bond is created by forming on the pad 204 of the flexible substrate 100 a conductive ball 206 and a wire 208 that extends from the ball 206. The ball 206 is formed from a material that has the desired thermal and conductive properties, e.g., Au. The wire 208 is then cut at the base, as indicated by broken line 210, and discarded leaving the conductive stud bump 202. A finished stud bump 202 is shown in Fig. 3B. As illustrated, the stud bump 202 has a bump diameter D₂₀₂, which may be, e.g., 90-100µm; a ball height H₂₀₆, which may be, e.g., 20-25µm; and a bump height H₂₀₂, which may be, e.g., 40-50µm. Because the production of stud bumps 202 in this manner is based primarily on the production of a wire bond, which is well known in the art, the dimensions of the stud bumps 202 may be controlled to fit design needs, such as optical height requirements, as is well within the abilities of those skilled in the art. It should be understood, of course, that other dimensions may be used if desired.

If desired, the conductive bumps may be produced on the contacts of the LED 102 instead of the pads of the flexible substrate 100. Moreover, other types of connecting means, instead of stud bumps, may be used to connect the LED 102 to the flexible substrate 100. For example, plated thick contact bumps of Au may be used in place of stud bumps.

As illustrated in Fig. 4, a semiconductor light emitting device, such as LED 102 is then thermosonically bonded to the flexible substrate 100. Fig. 4 illustrates a cross section of the LED 102 with an n-type layer 102a that is electrically connected to a first contact 220a; a p-type layer 102b that is electrically connected to a second contact 220b; and an active region 102c interposing the n-type layer 102a and the p-type layer 102b. The contacts 220a and 220b on the LED 102 are aligned with the stud bumps 202 while the flexible substrate 100 is heated on a stage to approximately 150-160°C. A bond force of, e.g., approximately 50-100gm/bump, is applied to the LED 102 by bonding tool 222, as indicated by arrow 224, while ultrasonic vibration is applied, as indicated by arrow 226. The Zener diode 104, if used, may be attached using the same process. If desired, a thermo-compression process may be used to bond the LEDs 102 to the flexible substrate 100. As is well known in the art, with thermo-compression higher temperatures and greater bonding forces are typically required.

If desired, an underfill material may be deposited prior to encapsulating the LED 102, particularly, when the LED 102 has a large die size. For example, a no-flow underfill can be deposited prior to the thermosonic bonding process. Alternatively, an underfill material can be applied after the thermosonic die attachment process.

Once the LED 102 is attached to the flexible substrate 100, the entire structure may be covered with an encapsulant 230, as illustrated in Fig. 5, which may serve as a lens. The encapsulant 230 may be a transparent molding compound that is soft compliant material. Suitable molding compounds may be purchased, e.g., from Shin-Etsu Chemical Co., Ltd., of Japan and NuSil Silicone Technology of Santa Barbara, California. Additionally, if desired, a wavelength converting material, such as a phosphor coating, may be deposited on top of the LED-flex assemblies prior to encapsulating the LEDs102.

When the encapsulant 230 is cured, the LED 102 can be singulated from the flexible substrate 100 according to design needs, as discussed above. As illustrated in Fig. 5, a device with a small footprint may be produced by singulating the LED 102 near the encapsulant 230, e.g., along broken lines 232. It should be understood that if a Zener diode is used (or multiple LEDs), the Zener diode (or other LEDs) should be singulated with LED 102 shown in Fig. 5. Once singulated, the metal contacts 234, which may be, e.g., copper or gold, on the bottom surface of the flexible substrate 100, i.e., on the side of the flexible substrate 100 opposite to the attached LED 102, can be directly attached to the end user's board, e.g., with reflow PbSn eutectic or Pb-free solder. The contacts 234 are electrically and thermally connected to the pads 204 on the top surface of the flexible substrate 100, e.g., with vias 236. Thermal management of the LED package can be controlled by the end user. For example, once singulated the LED may be used as is or a heat spreader may be added as the application demands.

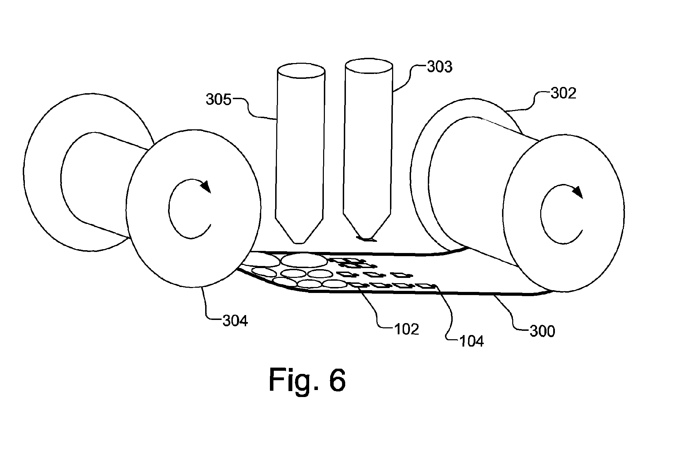

Alternatively, the flexible substrate 100 with attached LEDs 102 may be shipped without singulation. The use of the flexible substrate 100 advantageously obviates the need for a separate tape and reel process, which is conventionally used for shipping. Fig. 6 shows a perspective view of a flexible substrate 300 being spooled on a reel, e.g., for bonding and shipping purposes. As illustrated, the flexible substrate 300 is unspooled from a first reel 302 and after LEDs 102 and Zener diodes 104 are attached by bonding head 303, as discussed above, the encapsulant is deposited on the devices by head 305, and the encapsulant is cured, e.g., by heating. The flexible substrate 300 is then spooled on a second reel 304. Thus, the fmished flexible substrate 300 with attached LEDs 102 and Zener diodes 104 can be easily shipped and does not require a separate tape and reel process.

It should be understood that while the bumps 202 have been described herein as gold stud bumps or plates, other materials may be used if desired. By way of example, AuSn, AuGe, AuSi, may be used for the bumps 202. However, care should be taken that the material used for bumps 202 has a melting point that is sufficiently high, e.g., greater than 280°C, that the contact between the LED 102 and flexible substrate 100 is not damaged when the flexible circuit 100 is connected to the end user's board, e.g., by solder reflow.

Although the present invention is illustrated in connection with specific embodiments for instructional purposes, the present invention is not limited thereto. Various adaptations and modifications may be made without departing from the scope of the invention. Therefore, the spirit and scope of the appended claims should not be limited to the foregoing description.

## Claims

1. A device comprising:
a semiconductor light emitting device comprising:
an n-type layer;
a p-type layer;
an active region interposing the n-type layer and the p-type layer;
an n-contact electrically connected to the n-type layer; and
a p-contact electrically connected to the p-type layer;
wherein the n- and p-contacts are formed on a same side of the semiconductor light emitting device; and
a flexible substrate comprising a flexible layer and first and second conductive regions on a first side of the flexible layer, wherein the n- and p-contacts of the semiconductor light-emitting device are electrically and physically bonded to the first and second conductive regions of the flexible substrate in a flip chip configuration.

2. The device of claim 1, further comprising conductive material disposed between the n- and p- contacts of the semiconductor light emitting device and the respective first and second conductive regions of the flexible substrate.

3. The device of claim 2,wherein the conductive material is comprised of gold.

4. The device of claim 2,wherein the conductive material disposed between the n- and p- contacts of the semiconductor light emitting device and the respective first and second conductive regions is in the form of a stud bump.

5. The device of claim 1,further comprising:
a second semiconductor light emitting device comprising:
an n-type layer;
a p-type layer;
an active region interposing the n-type layer and the p-type layer;
an n-contact electrically connected to the n-type layer; and
a p-contact electrically connected to the p-type layer;
wherein the n- and p-contacts are formed on a same side of the second semiconductor light emitting device; and
wherein the flexible substrate further comprises third and fourth conductive regions on the first side of the flexible layer, wherein the n- and p-contacts of the second semiconductor light emitting device are electrically and physically bonded to the third and fourth conductive regions of the flexible substrate in a flip chip configuration.

6. The device of claim 1, further comprising:
a plurality of semiconductor light emitting devices each comprising:
an n-type layer;
a p-type layer;
an active region interposing the n-type layer and the p-type layer;
an n-contact electrically connected to the n-type layer; and
a p-contact electrically connected to the p-type layer;
wherein the n- and p-contacts are formed on a same side of each semiconductor light emitting device; and
wherein the flexible substrate further comprises a plurality of conductive regions on the first side of the flexible layer, wherein the n- and p-contacts of each of the plurality of semiconductor light emitting devices are electrically and physically bonded to a respective one of the plurality of conductive regions of the flexible substrate in a flip chip configuration.

7. The device of claim 1, further comprising third and fourth conductive regions on a second side of the flexible layer, wherein the first and third conductive regions are electrically connected and the second and fourth conductive regions are electrically connected.

8. The device of claim 1,wherein the flexible layer is a polyimide material.

9. A structure comprising:
a flexible substrate having a plurality of contact regions on a first side; and
a plurality of semiconductor light emitting devices, each of the plurality of semiconductor light emitting devices having a first contact and a second contact located on the same side of the semiconductor light emitting device, each of the plurality of semiconductor light emitting devices having a first and second contact that is electrically and physically connected to an associated contact region on the flexible substrate in a flip chip configuration.

10. The structure of claim 9, wherein at least a portion of the plurality of semiconductor light emitting devices are electrically connected on the flexible substrate.

11. The structure of claim 10, wherein at least a second portion of the plurality of semiconductor light emitting devices are individually isolated on the flexible substrate.

12. The structure of claim 9, further comprising gold stud bumps disposed between the contact regions on the flexible substrate and the respective first contact and second contact of each of the plurality of semiconductor light emitting devices.

13. The structure of claim 9, further comprising a reel, wherein the flexible substrate and connected plurality of semiconductor light emitting devices is spooled on the reel.

14. A method comprising:
providing a flexible substrate with a plurality of contact regions;
providing a plurality of semiconductor light emitting devices, each of the plurality of semiconductor light emitting devices having a first contact and a second contact located on the same side of the semiconductor light emitting device;
forming a gold bump on the plurality of contact regions on the flexible substrate or the first contact and second contact on each of the plurality of semiconductor light emitting devices;
bonding each of the first contact and second contact of each of the plurality of semiconductor light emitting devices to an associated contact region of the flexible substrate with a gold bump; and
encapsulating each of the plurality of semiconductor light emitting devices on the flexible substrate.

15. The method of claim 14, further comprising spooling the flexible substrate with bonded semiconductor light emitting devices onto a reel.

16. The method of claim 14, further comprising singulating individual semiconductor light emitting devices from the flexible substrate.

17. The method of claim 14, further comprising singulating groups of semiconductor light emitting devices from the flexible substrate.

18. The method of claim 14, wherein forming a gold bump comprises forming gold stud bumps on the plurality of contact regions on the flexible substrate or the first contact and second contact on each of the plurality of semiconductor light emitting devices.

19. The method of claim 14, wherein bonding each of the first contact and second contact of each of the plurality of semiconductor light emitting devices to an associated contact region of the flexible substrate with a gold bump is performed thermosonically.

20. The method of claim 14, wherein providing a flexible substrate with a plurality of contact regions comprises:
providing a flexible substrate comprising a polyimide layer and a copper layer; and
etching the copper layer to form the desired plurality of contact regions.
